(19) Europäisches Patentamt
European Patent Office
Office européen des brevets

(11) **EP 2 605 285 B1**

(12) **EUROPEAN PATENT SPECIFICATION**

(45) Date of publication and mention
of the grant of the patent:
**06.05.2020 Bulletin 2020/19**

(51) Int Cl.:
*H01L 31/0224* *(2006.01)* *H01L 31/068* *(2012.01)*

(21) Application number: **12181566.6**

(22) Date of filing: **23.08.2012**

(54) **Photovoltaic device**

Photovoltaische Vorrichtung

Dispositif photovoltaïque

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.12.2011 US 201161569946 P**
**14.08.2012 US 201213584917**

(43) Date of publication of application:
**19.06.2013 Bulletin 2013/25**

(73) Proprietor: **Intellectual Keystone Technology LLC McLean, VA 22102 (US)**

(72) Inventors:
• **Kim, Young-Su**
**Gyeonggi-do (KR)**
• **Mo, Chan-Bin**
**Gyeonggi-do (KR)**

(74) Representative: **Mounteney, Simon James**
**Marks & Clerk LLP**
**15 Fetter Lane**
**London EC4A 1BW (GB)**

(56) References cited:
EP-A1- 2 284 907     WO-A1-2010/125861
DE-A1-102007 013 553     DE-A1-102009 003 467
JP-A- 2006 120 945     JP-A- 2007 281 044
KR-A- 20100 064 478     US-A1- 2008 017 243

**Description**

**BACKGROUND OF THE INVENTION**

**Field of the invention**

The present invention relates to a photovoltaic device.

**Description of Related Art**

In order to manufacture a photovoltaic device, a p-n junction is formed by doping an n-type (or p-type) dopant into a p-type (or n-type) substrate so as to form an emitter. Electron-hole pairs formed by receiving light are separated, and then electrons are collected by an electrode of an n-type area and holes are collected by an electrode of a p-type area, thereby generating electric power.

A photovoltaic device may have a structure in which an electrode is provided at each of a front surface, which is a light-receiving surface, and a back surface. When an electrode is provided at the front surface, the light-receiving area is decreased by the area of the electrode. To address this problem of a decrease in the light-receiving area, a back contact structure in which electrodes are provided only on a back surface is used.

The present invention sets out to provide a back-electrode type photovoltaic device having improved efficiency relative to the prior art. Document DE 10 2009 003467 A1 discloses a photovoltaic device provided with emitter electrodes and base electrodes on the back surface of the substrate.

**SUMMARY OF THE INVENTION**

-According to the invention, there is provided a photovoltaic device as set out in Claim 1. Preferred features of the invention are set out in Claims 2 to 15.

**BRIEF DESCRIPTION OF THE DRAWINGS**

FIG. 1 is a perspective view schematically illustrating a photovoltaic device according to an embodiment of the present invention.
FIG. 2 is a cross-sectional view taken along line II-II of FIG. 1.
FIG. 3 is a bottom view illustrating a bottom surface of the photovoltaic device according to an embodiment of the present invention.
FIG. 4 is a graph showing a series resistance according to a width ratio of a first electrode and a second electrode.
FIGS. 5 through 7 are cross-sectional views schematically illustrating photovoltaic devices according to other embodiments of the present invention.
FIGS. 8A through 12 are cross-sectional views schematically illustrating states of a method of manufacturing a photovoltaic device according to an embodiment of the present invention.

**DETAILED DESCRIPTION**

The merits and characteristics of the present invention and a method to achieve the same will be clearly shown with reference to the attached drawings and the below-described embodiments of the present invention. Exemplary embodiments are provided to further completely explain the present inventive concept to one skilled in the art to which the present invention pertains. The present invention is defined by the scope of the claims.

The terminology used herein is for the purpose of describing particular embodiments only and is not intended to be limiting of exemplary embodiments. As used herein, the singular forms "a/an" and "the" are intended to include the plural forms (a plurality of) as well, unless the context clearly indicates otherwise. It will be further understood that the terms "comprises" and/or "comprising" when used in this specification, specify the presence of stated features, integers, steps, operations, elements, and/or components, but do not preclude the presence or addition of one or more other features, integers, steps, operations, elements, components, and/or groups thereof. The terms such as "first" and "second" are used herein merely to describe a variety of constituent elements, but the constituent elements are not limited by the terms. The terms are used only for the purpose of distinguishing one constituent element from another constituent element.

In the drawings, the thicknesses of layers, regions, and films are exaggerated for clarity. It will also be understood that when a layer is referred to as being "on" another layer or substrate, it can be "directly on" the other layer or substrate, or intervening layers may also be present. Conversely, when a constituent element is described to be "directly on" another constituent element, the constituent element should be construed to be directly connected to another constituent element without any other constituent element interposed therebetween.

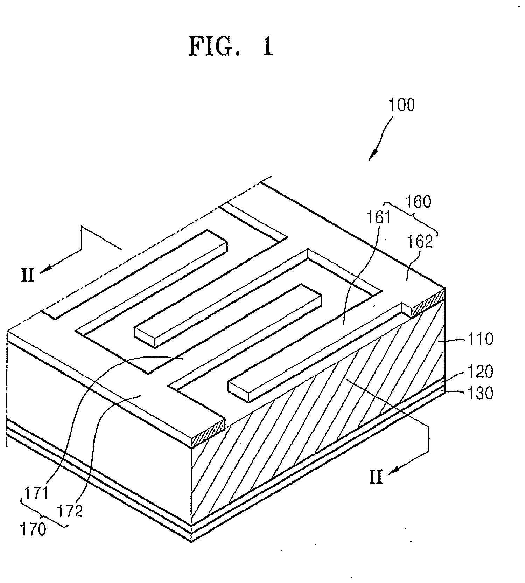

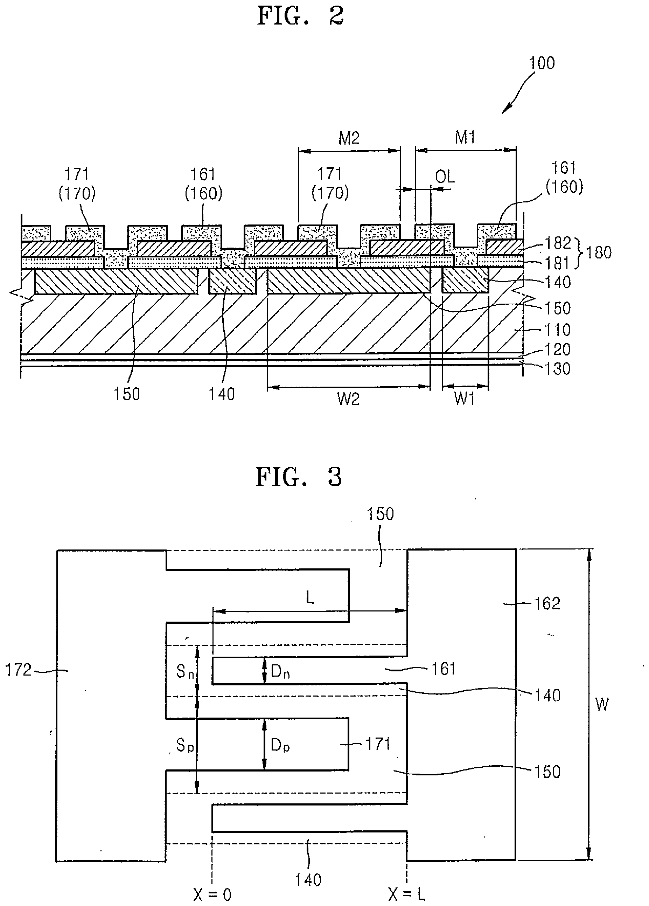

FIG. 1 is a perspective view schematically illustrating a photovoltaic device 100 according to an embodiment of the present invention. FIG. 2 is a cross-sectional view taken along line II-II of FIG. 1.

Referring to FIGS. 1 and 2, the photovoltaic device 100 according to the present embodiment includes a semiconductor substrate 110, a passivation layer 120 and an anti-reflection layer 130 formed on a first surface of the semiconductor substrate 110, a base region 140 and an emitter region 150 formed in a second surface of the semiconductor substrate 110, a first electrode 160 electrically connected to the base region 140, and a second electrode 170 electrically connected to the emitter region 150. An insulation layer 180, including a first insulation layer 181 and a second insulation layer 182, is provided between the base and emitter regions 140 and 150 and the first and second electrodes 160 and 170.

The semiconductor substrate 110 may be formed of crystal silicon or a compound semiconductor. For example, a silicon wafer may be used as the semiconductor substrate 110. The semiconductor substrate 110 may be doped with an n-type impurity or a p-type impurity. The p-type impurity may be a Group III compound such as boron (B) and aluminum (Al). The n-type impurity may be a Group V compound such as phosphorus (P).

The semiconductor substrate 110 has a first surface and a second surface that is opposite to the first surface. The first surface is a light-receiving surface and emitter and base electrodes (first and second electrodes 160 and 170) are provided on the second surface.

The passivation layer 120 is provided on the first surface of the semiconductor substrate 110 and serves to improve the efficiency of collection of carriers by preventing surface recombination of carriers generated by the semiconductor substrate 110. For example, the passivation layer 120 prevents the carriers from moving to the first surface of the semiconductor substrate 110 so that electrons and holes may be prevented from being recombined at and near the first surface of the semiconductor substrate 110. The passivation layer 120 may be an intrinsic semiconductor layer or a doped semiconductor layer. Alternatively, the passivation layer 120 may be formed as a silicon oxide layer or a silicon nitride layer.

When the passivation layer 120 is an intrinsic semiconductor layer or a doped semiconductor layer, the passivation layer 120 may be formed of amorphous silicon deposited on the semiconductor substrate 110. For example, the passivation layer 120 may be formed of amorphous silicon doped in a first conductive type that is the same as the semiconductor substrate 110. The passivation layer 120 may be doped at a higher concentration than the semiconductor substrate 110 so as to form a front surface field (FSF) for preventing the surface recombination.

The anti-reflection layer 130 is formed on the passivation layer 120. The anti-reflection layer 130 prevents light absorption loss of the photovoltaic device 100 due to reflection of light when sunlight is incident, so that the efficiency of the photovoltaic device 100 may be improved. The anti-reflection layer 130 may be formed as a silicon oxide layer or a silicon nitride layer. For example, the anti-reflection layer 130 may be formed as a single silicon oxide layer or a combined layer including a silicon oxide layer and a silicon nitride layer having different refractive indexes.

Although in the present embodiment the passivation layer 120 and the anti-reflection layer 130 are formed as separate layers, the present invention is not limited thereto. In another embodiment, the passivation layer 120 and the anti-reflection layer 130 may be formed as one layer. For example, a silicon nitride layer is formed so that the effects of passivation and anti-reflection may be simultaneously obtained.

The base region 140 and the emitter region 150 are formed in the second surface of the semiconductor substrate 110. The base region 140 and the emitter region 150 are alternatingly formed. In this embodiment, the base region 140 and the emitter region 150 is formed in a striped pattern and parallel to each other. The emitter region 150 are formed to have a width larger than that of the base region 140. That is, the width W2 of the emitter region 150 is formed greater than the width W1 of the base region 140 so that a short-circuit current Jsc may be increased.

The base region 140 is doped with the same impurity type as the semiconductor substrate 110. The emitter region 150 is doped with an impurity type different from the semiconductor substrate 110. For example, when the semiconductor substrate 110 includes an n-type impurity, the base region 140 as an n+ region includes a lot of n-type impurities so that the generated electrons may be easily collected at the first electrode 160, and the emitter region 150 as a p+ region includes a lot of p-type impurities so that the generated holes may be easily collected at the second electrode 170. In another embodiment, the base region 140 may be a p+ region, whereas the emitter region 150 may be an n+ region.

The first electrode 160 includes a first bus bar 162 and a plurality of first finger electrodes 161 that are formed perpendicular to the first bus bar 162. The first finger electrodes 161 are arranged on the base region 140 to collect carriers. The first bus bar 162 is connected to the first finger electrodes 161 to transfer the carriers collected by the first finger electrodes 161 to the outside. The first electrode 160 may be formed of silver (Ag), gold (Au), copper (Cu), aluminum (Al), nickel (Ni), or a combination thereof.

The second electrode 170 includes a second bus bar 172 and a plurality of second finger electrodes 171 that are formed perpendicular to the second bus bar 172. The second finger electrodes 171 are arranged on the emitter region 150 to collect carriers. The second bus bar 172 is connected to the second finger electrodes 171 to transfer the carriers collected by the second finger electrodes 171 to the outside. The second electrode 170 may be formed of silver (Ag), gold (Au), copper (Cu), aluminum (Al), nickel (Ni), or a combination thereof.

The first and second finger electrodes 161 and 171 are alternatingly formed. The first finger electrodes 161 are electrically connected to the base region 140. The second finger electrodes 171 are electrically connected to the emitter region 150.

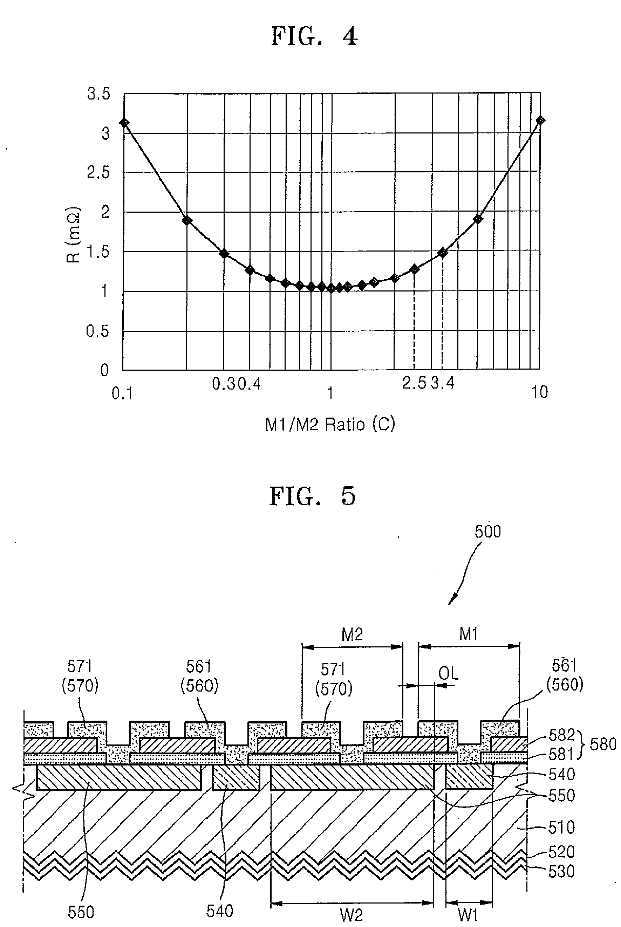

A ratio C (C=M1/M2) between the width M1 of each of the first finger electrodes 161 and the width M2 of each of the second finger electrodes 171 is in a range of from 0.3 to less than 1. In particular, the width ratio C may be in a range of from 0.4 to less than 1. A detailed description on the width ratio C will be presented below with reference to FIGS. 3 and 4.

The width M1 of each of the first finger electrodes 161 may be formed to be larger than the width W1 of the base region 140. The width M2 of each of the second finger electrodes 171 may be formed to be less than the width W2 of the emitter region 150. Since the width M1 of each of the first finger electrodes 161 is formed larger than the width W1 of the base region 140, there may be a region OL where the first finger electrode 161 overlaps with the emitter region 150. Since the second finger electrode 171 and the emitter region 150 in the overlap region OL have the opposite conduction types, a shunt may occur and the insulation layer 180 is provided to prevent the shunt.

The width of the OL region may be described as $OL \le (M1-W1)/2$. Even though the insulation layers are located between the emitter region and base electrode, the possibility of a shunt occurring between the emitter region and base electrode may increase as the value of OL is greater. In order to minimize this possibility and prevent efficiency reduction of the photovoltaic device, M1 may be decreased. That is, the shunt may be prevented under the condition that $M1 < M2$.

The insulation layer 180 includes the first and second insulation layers 181 and 182. The first and second insulation layers 181 and 182 are formed on the base region 140 and the emitter region 150 and under the first and second electrodes 160 and 170, thereby preventing a shunt between constituent elements having opposite conduction types. The first and second insulation layers 181 and 182 include via holes via which the first and second electrodes 160 and 170 may directly contact the base region 140 and the emitter region 150, respectively. The first electrode 160 may be electrically connected to the base region 140 through the via hole. The second electrode 170 may be electrically connected to the emitter region 150 through the via hole.

The first and second insulation layers 181 and 182 may be formed as a silicon oxide (SiOx) layer or a silicon nitride (SiNx) layer. For example, the first insulation layer 181 may be formed as a silicon oxide layer and the second insulation layer 182 may be formed as a silicon nitride layer. Alternatively, the first insulation layer 181 may be formed as a silicon nitride layer and the second insulation layer 182 may be formed as a silicon oxide layer. The first and second insulation layers 181 and 182 each may be formed to have a thickness of from 500 Å to 3000 Å.

In another embodiment of the present invention, the first insulation layer 181 may be formed as a silicon oxide (SiOx) layer or a silicon nitride (SiNx) layer and the second insulation layer 182 may be formed of polyimide. Alternatively, the second insulation layer 182 may be formed of ethylenevinylacetate (EVA), polyethylene terephthalate (PET), or polycarbonate (PC). The first insulation layer 181 may be formed to have a thickness of from 500 Å to 3000 Å, and the second insulation layer 182 may be formed to have a thickness of from 0.5 $\mu$m to 30 $\mu$m.

In the photovoltaic device 100 according to this embodiment of the present embodiment, the width W2 of the emitter region 150 is formed larger than that of the base region 140 to increase a short-circuit current Jsc. Also, to reduce the series resistance, the first and second electrodes 160 and 170, in detail, the first and second finger electrodes 161 and 171, are formed to have a predetermined width ratio C therebetween. When the width ratio C of the first and second finger electrodes 161 and 171 is out of this range, the resistance of at least one of the first and second finger electrodes 161 and 171 may be increased so that an overall efficiency of the photovoltaic device 100 may be reduced.

The ratio C between the widths M1 and M2 of the first and second finger electrodes 161 and 171 of the photovoltaic device 100 according to the present embodiment (C=M1/M2) will now be described with reference to FIGS. 3 and 4.

FIG. 3 is a bottom view illustrating a bottom surface of the photovoltaic device 100 according to this embodiment of the present invention. FIG. 4 is a graph showing a series resistance R according to the width ratio C (=M1/M2) of a first electrode and a second electrode. Although in FIG. 3 the number of first and second finger electrodes 161 and 171 is two, this is a mere illustration of a portion of the photovoltaic device 100 and the number of first and second finger electrodes 161 and 171 is not limited thereto.

Parameters in FIG. 3 are as follows.

Dn: the width of the first finger electrode 161, Dn=M1
Dp: the width of the second finger electrode 171, Dp=M2
Sn: the width of the base region 140, Sn=W1
Sp: the width of the emitter region 150, Sp=W2

Nn: the number of first finger electrodes 161
Np: the number of second finger electrodes 171
L: the length of each of the finger and second electrodes 161 and 171, L » Dn,Dp
W: the width of the photovoltaic device 100

Accordingly, W=Sn×(Number of base regions) + Spx(Number of emitter regions)

Cell pitch: Sn+Sp

Power loss $P_n$ by the first finger electrode 161 having a length L can be expressed by Equation (1).

$$P_n = \int i^2 dr_n = \int_0^L (J_n s_n x)^2 \frac{\rho}{D_n t} dx = \frac{J_n^2 s_n^2 \rho L^3}{3 D_n t} \quad \dots \dots (1)$$

$$N_n = N_p = \frac{N}{2},$$

When the number of first and second finger electrodes 161 and 171 is the same, that is, the total power loss P can be expressed by Equation (2).

$$P = (P_n + P_p) \frac{N}{2} = \frac{\rho L^3 N}{6t} \left( \frac{J_n^2 s_n^2}{D_n} + \frac{J_p^2 s_p^2}{D_p} \right) \quad \dots \dots (2)$$

However,

$$J_n = \frac{I_{mp}}{L s_n (N/2)}, J_p = \frac{I_{mp}}{L s_p (N/2)}$$

The total power loss P of the photovoltaic device 100 can be expressed by $I_{mp}^2 R$ · At this time, the total power loss P of Equation (2) can be expressed by Equation (3).

$$\frac{\rho L^3 N}{6t} \left( \frac{\left[ \frac{I_{mp}}{L s_n (N/2)} \right]^2 s_n^2}{D_n} + \frac{\left[ \frac{I_{mp}}{L s_p (N/2)} \right]^2 s_p^2}{D_p} \right) = I_{mp}^2 R \quad \dots \dots (3)$$

When Equation (3) is summarized, Equation (4) is obtained.

$$R = \frac{2 \rho L}{3tN} \left( \frac{1}{D_n} + \frac{1}{D_p} \right) \dots \dots (4)$$

A metal coverage k that is an area ratio of the first and second finger electrodes 161 and 171 to the second surface of the photovoltaic device 100 can be expressed by Equation (5).

$$k = \frac{(D_n + D_p)L\frac{N}{2}}{WL} \quad \dots \dots (5)$$

When Equation (5) is solved for the series resistance R, Equation (6) is obtained.

$$R = \frac{\rho L}{3tkW}\frac{(D_n + D_p)^2}{D_n D_p} \quad \dots \dots (6)$$

When $D_y = CD_n$ is substituted in Equation (6), Equation (7) is obtained.

$$R = \frac{\rho L}{3tkW}\frac{(C+1)^2}{C} \quad \dots \dots (7)$$

$$R_{min} = \frac{4\rho L}{3tkW} \text{ when } C=1 \quad \dots \dots (8)$$

When a value of the series resistance R according to the width ratio C value (M1/M2, Dn/Dp) based on Equation (7) is presented in a graph of FIG. 4. Referring to the FIG. 4, the series resistance R has a minimum value when C=1 as shown in Equation (8), and the graph of the series resistance R is bilaterally symmetrical about a point where C=1.

Referring to FIG. 4, the ratio C of the widths M1 and M2 of the first and second finger electrodes 161 and 171 may have a ratio of about 0.3 to 3.4. If the width ratio C is less than about 0.3 or exceeds about 3.4, it can be seen from FIG. 4, that the series resistance R increases significantly. That is, if the width ratio C exceeds a range of $0.3 \leq C \leq 3.4$, the series resistance R increases such that the overall efficiency of the photovoltaic device 100 may be reduced.

In detail, the ratio C of the widths M1 and M2 of the first and second finger electrodes 161 and 171 may have a ratio of about 0.4 to 2.5. Considering a drop rate of a fill factor based on a value of the fill factor when C=1, the width ratio C may have a range of $0.4 \leq C \leq 2.5$. This will now be illustrated in detail with reference to [Table 1].

[Table 1]

| C | R (mΩ) | F.F. drop (%) |
|---|---|---|
| 0.1 | 3.142857 | 2.72 |
| 0.2 | 1.897861 | 1.64 |
| 0.3 | 1.478992 | 1.28 |
| 0.4 | 1.270997 | 1.1 |
| 0.5 | 1.16359 | 1.01 |
| 0.6 | 1.105569 | 0.96 |
| 0.7 | 1.070911 | 0.93 |
| 0.8 | 1.051474 | 0.91 |
| 0.9 | 1.051474 | 0.91 |
| 1 | 1.038961 | 0.9 |
| 1.1 | 1.042061 | 0.9 |
| 1.2 | 1.051474 | 0.91 |

(continued)

| C | R (mΩ) | F.F. drop (%) |
|---|---|---|
| 1.4 | 1.070911 | 0.93 |
| 1.6 | 1.105569 | 0.96 |
| 2 | 1.16359 | 1.01 |
| 2.5 | 1.270997 | 1.1 |
| 3.4 | 1.478992 | 1.28 |
| 5 | 1.897861 | 1.64 |
| 10 | 3.142857 | 2.72 |

[Table 1] shows a fill factor and a series resistance R according to a width ratio C value in the photovoltaic device 100 according to the present invention (top third to ninth value rows of Table 1). In the photovoltaic device 100 according to the present example, not covered by the present invention, the first and second finger electrodes 161 and 171 are formed to have the same widths and include copper with a thickness of about 35 $\mu$m and a cell pitch of about 1500 $\mu$m.

Referring to [Table 1], in the photovoltaic device 100 having a cell pitch of about 1500 $\mu$m, a drop rate of a fill factor (F.F. drop) when C=1, that is, M1=M2, is about 0.9%. Considering an error range of about ±10% for the F.F. drop when C=1, C may have a range of $0.4 \le C \le 2.5$.

FIG. 5 is a cross-sectional view schematically illustrating a photovoltaic device 500 according to another embodiment of the present invention.

Referring to FIG. 5, the photovoltaic device 500 according to the present embodiment includes a semiconductor substrate 510, a passivation layer 520 and an anti-reflection layer 530 formed on a first surface of the semiconductor substrate 510, a base region 540 and an emitter region 550 formed on a second surface of the semiconductor substrate 510, a first electrode 560 electrically connected to the base region 540, and a second electrode 570 electrically connected to the emitter region 550. An insulation layer 580, including a first insulation layer 581 and a second insulation layer 582, is provided between the base and emitter regions 540 and 550 and the first and second electrodes 560 and 570.

In the photovoltaic device 500 according to the present embodiment, the base region 540 and the emitter region 550 are formed in a striped pattern and parallel to each other. The emitter region 550 is formed to have a width larger than that of the base region 540. That is, the width W2 of the emitter region 550 is formed greater than the width W1 of the base region 540 so that a short-circuit current Jsc may be increased.

The width M1 of each of the first finger electrodes 561 is greater than the width W1 of the base region 540. The width M2 of each of the second finger electrodes 571 is less than the width W2 of the emitter region 550. Since the width M1 of each of the first finger electrodes 561 is formed greater than the width W1 of the base region 540, a region OL where the first finger electrode 561 overlaps with the emitter region 550 is formed.

A ratio C (C=M1/M2) between the width M1 of each of the first finger electrodes 561 and the width M2 of each of the second finger electrodes 571 is in a range of from 0.3 to less than 1. In particular, the width ratio C may be in a range of from 0.4 to less than 1. In an example not covered by the present invention, the width ratio C may be 1.0 so that the width M1 of each of the first finger electrodes 561 and the width M2 of each of the second finger electrodes 571 may have substantially the same value.

However, the photovoltaic device 500 according to the present embodiment is different from the photovoltaic device 100 of FIG. 2 in terms of the shape of its light-receiving surface. For convenience of explanation, only a difference between the embodiments will now be described below and repeated descriptions are omitted.

A first surface of the semiconductor substrate 510 is surface-textured. In various embodiments of the invention, the surface-texture may include an uneven pattern, for example, a pyramid or honeycomb shape. The semiconductor substrate 510 that is surface-textured has an increased surface area so as to increase a light absorption rate and decrease a reflection rate, thereby improving the efficiency of the photovoltaic device 500.

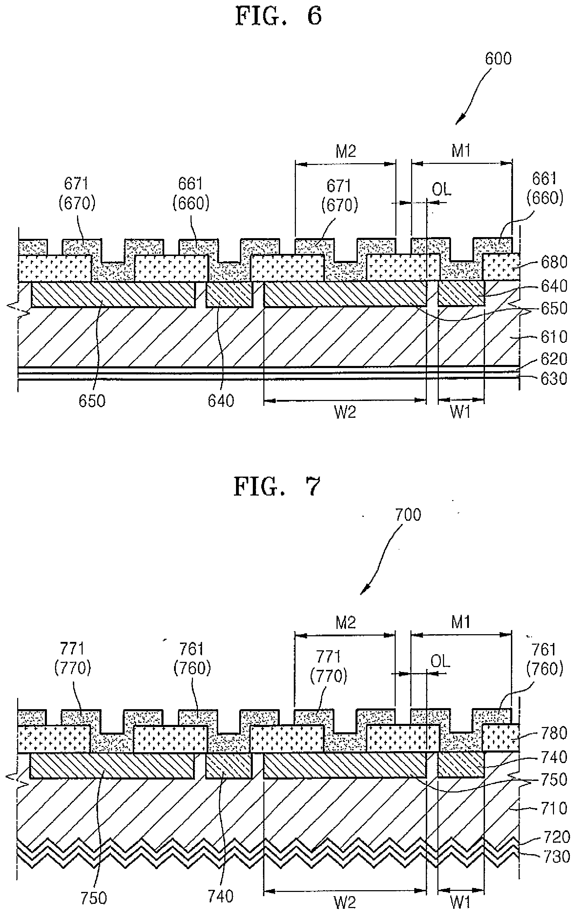

FIGS. 6 and 7 are cross-sectional views schematically illustrating photovoltaic devices 600 and 700 according to other embodiments of the present invention.

Referring to FIG. 6, the photovoltaic device 600 according to the present embodiment includes a semiconductor substrate 610, a passivation layer 620 and an anti-reflection layer 630 formed on a first surface of the semiconductor substrate 610, a base region 640 and an emitter region 650 formed on a second surface of the semiconductor substrate 610, a first electrode 660 electrically connected to the base region 640, and a second electrode 670 electrically connected to the emitter region 650. An insulation layer 680 is located between the base and emitter regions 640 and 650 and the first and second electrodes 660 and 670.

In the photovoltaic device 600 according to the present embodiment, the base region 640 and the emitter region 650 are formed in a striped pattern and parallel to each other. The width W2 of the emitter region 650 is formed greater than the width W1 of the base region 640. As the width W2 of the emitter region 650 is formed greater than the width W1 of the base region 640, a short-circuit current Jsc may be increased.

The width M1 of each of the first finger electrodes 661 is greater than the width W1 of the base region 640. The width M2 of each of the second finger electrodes 671 is less than the width W2 of the emitter region 650. Since the width M1 of the first finger electrode 661 is formed greater than the width W1 of the base region 640, a region OL where the first finger electrode 661 overlaps with the emitter region 650 may be formed.

A ratio C (C=M1/M2) between the width M1 of each of the first finger electrodes 661 and the width M2 of each of the second finger electrodes 671 is in a range of from 0.3 to less than 1. In particular, the width ratio C may be in a range of from 0.4 to less than 1. In an example not covered by the present invention, the width ratio C may be 1.0 so that the width M1 of each of the first finger electrodes 661 and the width M2 of each of the second finger electrodes 671 may have substantially the same value.

However, the photovoltaic device 600 according to the present embodiment is different from the photovoltaic device 100 of FIG. 2 in that the insulation layer 680 is formed as a single layer. For convenience of explanation, only a difference between the embodiments will now be described and a repeated description is omitted.

The insulation layer 680 is formed on the base region 640 and the emitter region 650 and under the first and second electrodes 660 and 670, thereby preventing a shunt between constituent elements having opposite conduction types. The insulation layer 680 includes via holes through which the first and second electrodes 660 and 670 directly contact the base region 640 and the emitter region 650, respectively. The first electrode 660 is electrically connected to the base region 640 through the via hole. The second electrode 670 is electrically connected to the emitter region 650 through the via hole.

The insulation layer 680 may be formed of a silicon oxide layer SiOx or a silicon nitride layer SiNx. For example, the insulation layer 680 may be formed with a thickness of about 8000 Å or more. A pin hole may be formed in the insulation layer 680 that is formed of a silicon oxide layer and a silicon nitride layer. Since the insulation layer 680 is a single layer, if the insulation layer 680 is formed with a thickness of less than about 8000 Å, a shunt may occur between the first finger electrodes 661 and the emitter region 650 through the pin hole formed in the insulation layer 680.

Referring to FIG. 7, the photovoltaic device 700 according to the present embodiment includes a semiconductor substrate 710, a passivation layer 720 and an anti-reflection layer 730 formed on a first surface of the semiconductor substrate 710, a base region 740 and an emitter region 750 formed on a second surface of the semiconductor substrate 710, a first electrode 760 electrically connected to the base region 740, and a second electrode 770 electrically connected to the emitter region 750. An insulation layer 780 is located between the base and emitter regions 740 and 750 and the first and second electrodes 770 and 770.

While the other constituent elements are the same as those of the photovoltaic device 600 described with reference to FIG. 6, the photovoltaic device 700 is different from the photovoltaic device 600 of FIG. 6 only in the structure of a first surface of the semiconductor substrate 710.

The first surface of the semiconductor substrate 710 is surface-textured and includes an uneven pattern such as a pyramid or honeycomb shape. The surface-textured semiconductor substrate 710 increases a surface area so as to increase a light absorption rate and decreases a reflection rate so as to improve the efficiency of the photovoltaic device 700.

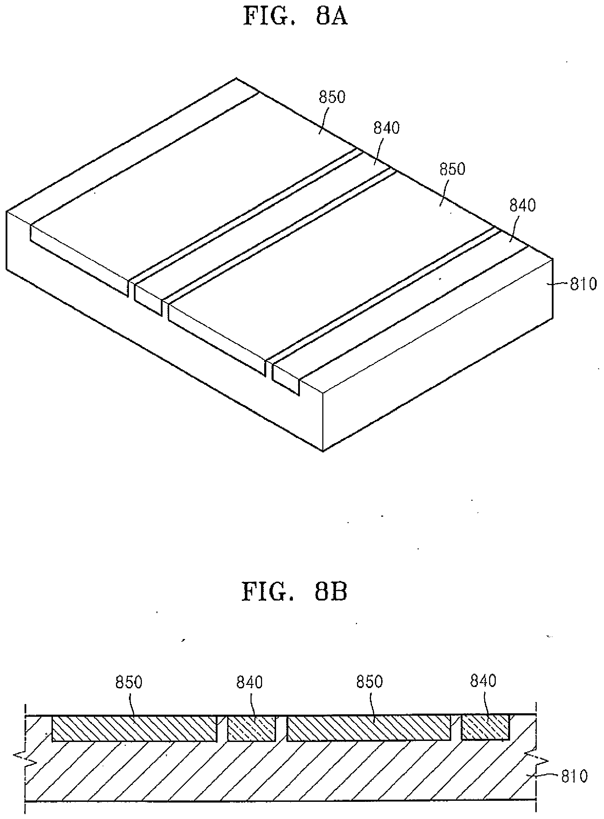

FIGS. 8A through 12 are cross-sectional views schematically illustrating states of a method of manufacturing a photovoltaic device according to the present invention. FIG. 8A is a cross-sectional perspective view of FIG. 8B.

First, a semiconductor substrate 810, for example, a silicon wafer, is prepared. The semiconductor substrate 810 may be doped with an n-type impurity or p-type impurity.

Referring to FIGS. 8A and 8B, a base region 840 and an emitter region 850 are formed in a second surface of the semiconductor substrate 810. The base region 840 and the emitter region 850 may be alternately formed. For example, the base region 840 and an emitter region 850 may be formed in a striped pattern and parallel to each other. The width W2 of the emitter region 850 may be greater than the width W1 of the base region 840 to increase a short-circuit current Jsc.

The base region 840 is doped with impurities of the same type as the semiconductor substrate 810. The emitter region 850 is doped with impurities of a different type from the semiconductor substrate 810. The impurities for forming the base region 840 and the emitter region 850 may be doped by a method such as an ion implant method or a thermal diffusion method.

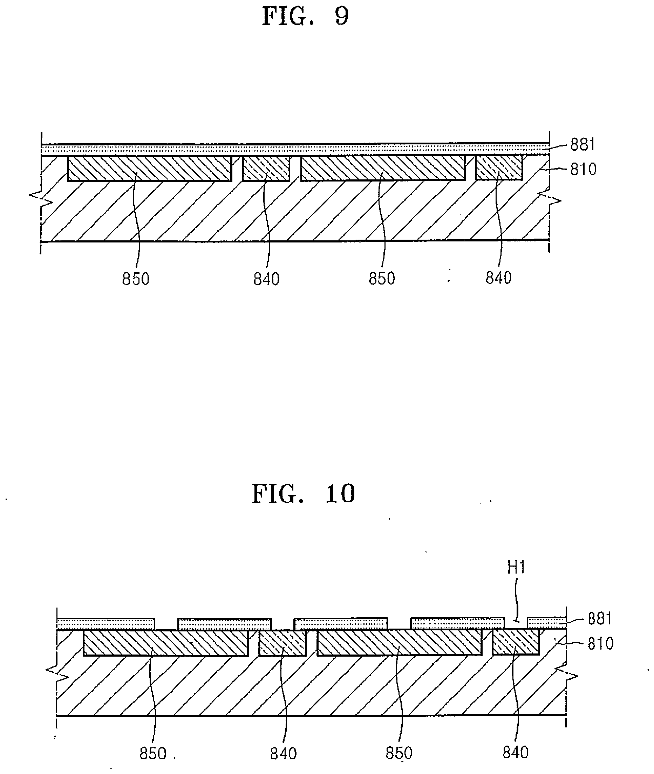

Referring to FIG. 9, a first insulation layer 881 may be formed of a silicon oxide layer SiOx or a silicon nitride layer SiNx. The first insulation layer 881 may be formed by a chemical vapor deposition (CVD) method. The first insulation layer 881 may be formed with a thickness of about 500 Å to 3000 Å.

Referring to FIG. 10, a plurality of first via holes H1 is formed in the first insulation layer 881. For example, after an etch prevention layer (not shown) is formed on the first insulation layer 881 that is formed according to the process described with reference to FIG. 9, the first via hole H1 may be formed by etching regions that are not protected by the etch prevention layer.

Also, in another method, the first via holes H1 may be formed by using etching paste. For example, etching paste is coated by a screen print method at locations where the first via holes H1 are to be formed. Next, a part of the first insulation layer 881 where the etching paste is formed is selectively etched by performing heat treatment for a predetermined time, and thus parts of the base region 840 and the emitter region 850 are exposed.

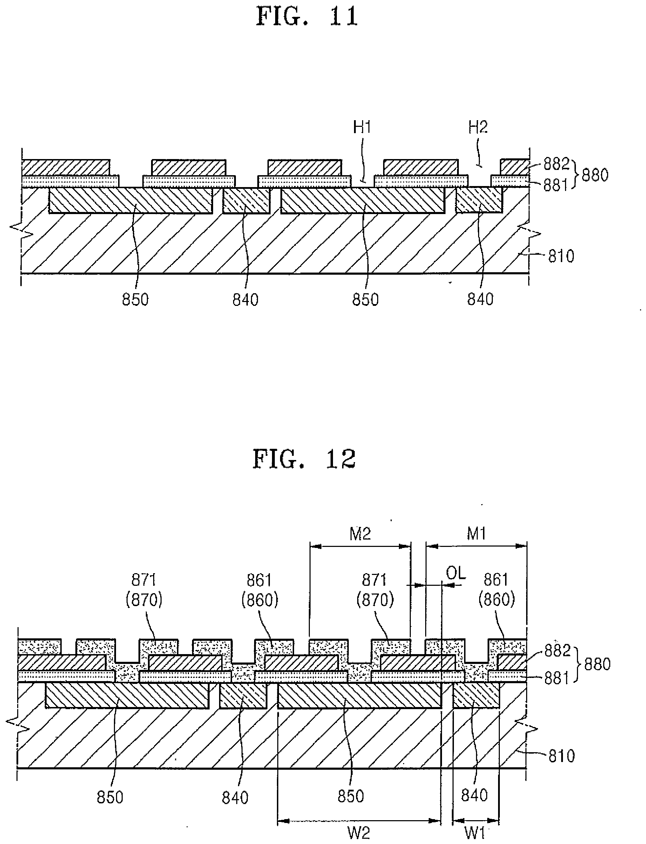

Referring to FIG. 11, a second insulation layer 882 is formed on the first insulation layer 881. The second insulation layer 882 may include a material such as polyimide, EVA, PET, or PC. The second insulation layer 882 may be formed to have a thickness of about 0.5 μm to 30 μm.

In another embodiment, the second insulation layer 882 may be formed of a silicon oxide layer SiOx or a silicon nitride layer SiNx. In this case, the second insulation layer 821 may be formed by a CVD method with a thickness of about 500 Å to 3000 Å.

The second insulation layer 882 includes a second via hole H2 in an area corresponding to a first via hole H1. When the second insulation layer 882 includes a material such as polyimide, the polyimide may be coated, leaving an area corresponding to the second via hole H2 uncoated. At this time, the polyimide may be coated on at least a part of the other area except for the area corresponding to the second via hole H2. Alternatively, when the second insulation layer 882 includes a silicon oxide layer or a silicon nitride layer, the second via hole H2 may be formed as described with reference to FIG. 10.

In the present embodiment, a case of forming an insulation layer 880 including the first and second insulation layers 881 and 882 has been described with reference to FIGS. 9 through 11. However, the insulation layer 880 may be formed as a single layer. The insulation layer 880 as a single layer may be formed as a silicon oxide layer SiOx or a silicon nitride layer SiNx. The insulation layer 880 may be formed with a thickness of about 8000 Å to prevent generation of a shunt due to the pin hole. The formation of a via hole in the insulation layer 880 as a single layer formed as silicon nitride layer or a silicon oxide layer is the same as that described with reference to FIG. 10.

Referring to FIG. 12, first and second electrodes 860 and 870 are formed. The first and second electrodes 860 and 870 may be formed by printing conductive paste including an element such as silver (Ag), gold (Au), copper (Cu), aluminum (Al), nickel (Ni), etc. through screen printing and then firing the same.

In another embodiment, seed layers (not shown) contacting the base region 840 and the emitter region 850 through the first and second via holes H1 and H2 are formed. The first and second electrodes 860 and 870 may be formed on the seed layers by metal plating.

The width M1 of each of the first finger electrodes 861 is greater than the width W1 of the base region 840. The width M2 of each of the second finger electrodes 871 is less than the width W2 of the emitter region 850. Since the width M1 of each of the first finger electrodes 861 is formed greater than the width W1 of the base region 840, a region OL where the first finger electrode 861 overlaps with the emitter region 850 is formed.

A ratio C (C=M1/M2) between the width M1 of each of the first finger electrodes 861 and the width M2 of each of the second finger electrodes 871 may be in a range of about 0.3 to less than 1. In detail, the width ratio C may be in a range of about 0.4 to less than 1. In an example not covered by the present invention, the width ratio C may be 1.0 so that the width M1 of each of the first finger electrodes 861 and the width M2 of each of the second finger electrodes 871 may have substantially the same value.

Although it is not illustrated, the first surface of the semiconductor substrate 810 may be surface-textured. The semiconductor substrate 810 that is surface-textured may include an uneven pattern, for example, a pyramid or honeycomb shape. The uneven pattern may be formed by performing, for example, anisotropic etching through wet etching or dry etching using plasma.

Also, although it is not illustrated, a passivation layer (not shown) and an anti-reflection layer (not shown) may be formed on the first surface of the semiconductor substrate 810 that is surface-textured. The passivation layer may be formed as an intrinsic semiconductor layer, a doped semiconductor layer silicon oxide layer, or a silicon nitride layer. The anti-reflection layer may be formed as a silicon oxide layer or a silicon nitride layer. For example, the anti-reflection layer may be formed of a chemical vapor deposition (CVD) method. The passivation layer and the anti-reflection layer may be formed as a single layer such as a silicon nitride layer that performs both functions of passivation and anti-reflection.

The process of forming the passivation layer and the anti-reflection layer may be performed before performing the process according to FIG. 8A, after performing the process according to FIG. 12, or during the process described with reference to FIGS. 8A to 12.

As described above, in the photovoltaic device according to the present invention, the emitter region may be formed to have a larger width than that of the base region so that short-circuit current may be generated, the width ratio C between the first and second finger electrodes is in a range of about 0.3 to less than 1, in particular, about 0.4 to less than 1, so that power loss due to the series resistance of the first and second electrodes may be reduced, and an overall efficiency of the photovoltaic device may be improved with an increase of a fill factor.

Also, since an area occupied by the first and second metal electrodes on the second surface of the semiconductor substrate is increased, reflection of light is induced so that short-circuit current may be improved.

Accordingly, in the photovoltaic device configured as above, even when a cell pitch is formed small to increase the lifetime of a carrier, that is, to reduce the extinction of the carrier, since the series resistance of the first and second electrodes is reduced and a fill factor and short-circuit current may be increased, the efficiency of the photovoltaic device may be improved.

**Claims**

1. A photovoltaic device (100) comprising:

   a substrate (110) including a light-receiving surface and a back surface;
   a base region (140) situated over the back surface of the substrate (110);
   an emitter region (150) situated over the back surface of the substrate (110);
   a first electrode (160) situated over the base region (140) and having a first electrode width M1 measured in a first direction; and
   a second electrode (170) situated over the emitter region (150) and having a second electrode width M2 measured in the said first direction;
   **characterised in that** $0.3 \leq C < 1$, where $C = M1/M2$.

2. A photovoltaic device according to claim 1, wherein $0.4 \leq C < 1$.

3. A photovoltaic device according to claim 1 or 2, wherein the width of the emitter region (150) in the first direction is greater than the width of the base region (140) in the first direction.

4. A photovoltaic device according to claim 1 or 2, wherein the width of the base region (140) in the first direction is greater than the width of the emitter region (150) in the first direction.

5. A photovoltaic device according to any preceding claim, comprising an insulating layer structure (180) situated between the base and emitter regions (140; 150) and the first and second electrodes (160; 170).

6. A photovoltaic device according to claim 5, wherein the insulating layer structure (180) comprises a single insulating layer (680; 780).

7. A photovoltaic device according to claim 5, wherein the insulating layer structure (180) comprises a first insulating layer (181; 581), and a second insulating layer (182; 582) situated over the first insulating layer (181; 581).

8. A photovoltaic device according to claim 5, 6 or 7, wherein the insulating layer structure (180) comprises insulating layer portions separated by openings, the first electrode (160) makes electrical contact with the base region (140) via a first one of the said openings and the second electrode (170) makes electrical contact with the emitter region (150) via a second one of the said openings.

9. A photovoltaic device according to claim 8 when dependent upon claim 7, wherein, within each insulating layer portion (180), the first insulating layer (181; 581) has a width measured in the first direction that is greater than a width of the second insulating layer (182; 582) measured in the first direction.

10. A photovoltaic device according to any one of claims 5 to 9, wherein the first electrode (160) overlaps an edge region of the emitter region (150) and the said insulating layer structure (180) is situated between the said edge region and the said first electrode (160; 170).

11. A photovoltaic device according to any one of claims 5 to 10, wherein the second electrode (170) overlaps an edge region of the base region (140) and the said insulating layer structure (180) is situated between the said edge region and the said second electrode (170).

12. A photovoltaic device according to claim 6 or any claim dependent thereon, wherein the insulating layer has a thickness of 8000 Å or more.

**13.** A photovoltaic device according to claim 7 or any claim dependent thereon, wherein each of the insulating layers has a thickness of from 500 Å to 3000Å.

**14.** A photovoltaic device according to any preceding claim, wherein the first and second electrodes (160, 170) are elongate and extend in a direction perpendicular to the first direction.

**15.** A photovoltaic device according to any preceding claim, wherein the base and emitter regions (140, 150) are elongate and extend in a direction perpendicular to the first direction.

**Patentansprüche**

**1.** Photovoltaische Vorrichtung (100), umfassend:

ein Substrat (110), umfassend eine lichtempfangende Oberfläche und eine Rückfläche;
einen Basisbereich (140), welcher oberhalb der Rückfläche des Substrats (110) angeordnet ist;
einen Emitterbereich (150), welcher oberhalb der Rückfläche des Substrats (110) angeordnet ist;
eine erste Elektrode (160), welche oberhalb des Basisbereichs (140) angeordnet ist, und eine erste Elektrodenbreite M1 gemessen in einer ersten Richtung aufweist; und
eine zweite Elektrode (170), welche oberhalb des Emitterbereichs (150) angeordnet ist und eine zweite Elektrodenbreite M2 aufweist, gemessen in der ersten Richtung;
**dadurch gekennzeichnet, dass** $0,3 \leq C < 1$, wobei $C = M1/M2$.

**2.** Photovoltaische Vorrichtung nach Anspruch 1, wobei $0,4 \leq C < 1$.

**3.** Photovoltaische Vorrichtung nach Anspruch 1 oder 2, wobei die Breite des Emitterbereichs (150) in der ersten Richtung größer als die Breite des Basisbereichs (140) in der ersten Richtung ist.

**4.** Photovoltaische Vorrichtung nach Anspruch 1 oder 2, wobei die Breite des Basisbereichs (140) in der ersten Richtung größer als die Breite des Emitterbereichs (150) in der ersten Richtung ist.

**5.** Photovoltaische Vorrichtung nach einem der vorhergehenden Ansprüche, umfassend eine isolierende Schichtstruktur (180), welche zwischen dem Basisbereich und den Emitterbereichen (140; 150) und der ersten und zweiten Elektrode (160; 170) angeordnet ist.

**6.** Photovoltaische Vorrichtung nach Anspruch 5, wobei die isolierende Schichtstruktur (180) eine einzelne isolierende Schicht (680; 780) umfasst.

**7.** Photovoltaische Vorrichtung nach Anspruch 5, wobei die isolierende Schichtstruktur (180) eine erste isolierende Schicht (181; 581) und eine zweite isolierende Schicht (182; 582) umfasst, welche oberhalb der ersten isolierenden Schicht (181; 581) angeordnet ist.

**8.** Photovoltaische Vorrichtung nach Anspruch 5, 6 oder 7, wobei die isolierende Schichtstruktur (180) isolierende Schichtabschnitte umfasst, welche durch Öffnungen getrennt sind, wobei die erste Elektrode (160) zu dem Basisbereich (140) über eine erste der Öffnungen und die zweite Elektrode (170) zu dem Emitterbereich (150) über eine zweite der Öffnungen elektrischen Kontakt herstellen.

**9.** Photovoltaische Vorrichtung nach Anspruch 8, wenn von Anspruch 7 abhängig, wobei in jedem isolierenden Schichtabschnitt (180), die erste isolierende Schicht (181; 581) eine Breite, gemessen in der ersten Richtung, aufweist, welche größer als eine Breite der zweiten isolierenden Schicht (182; 582), gemessen in der ersten Richtung, ist.

**10.** Photovoltaische Vorrichtung nach einem der Ansprüche 5 bis 9, wobei die erste Elektrode (160) einen Randbereich des Emitterbereichs (150) überlappt und die isolierende Schichtstruktur (180) zwischen dem Randbereich und der ersten Elektrode (160; 170) angeordnet ist.

**11.** Photovoltaische Vorrichtung nach einem der Ansprüche 5 bis 10, wobei die zweite Elektrode (170) einen Randbereich des Basisbereichs (140) überlappt und die isolierende Schichtstruktur (180) zwischen dem Randbereich und der zweiten Elektrode (170) angeordnet ist.

**12.** Photovoltaische Vorrichtung nach Anspruch 6 oder einem davon abhängigen Anspruch, wobei die isolierende Schicht eine Dicke von 8000 Å oder mehr aufweist.

**13.** Photovoltaische Vorrichtung nach Anspruch 7 oder einem davon abhängigen Anspruch, wobei jede der isolierenden Schichten eine Dicke zwischen 500 Å und 3000 Å aufweist.

**14.** Photovoltaische Vorrichtung nach einem der vorhergehenden Ansprüche, wobei die erste und zweite Elektrode (160; 170) länglich sind und sich in einer Richtung erstrecken, welche zur ersten Richtung senkrecht steht.

**15.** Photovoltaische Vorrichtung nach einem der vorhergehenden Ansprüche, wobei der Basisbereich und der Emitterbereich (140; 150) länglich sind und sich in einer Richtung erstrecken, welche zur ersten Richtung senkrecht steht.

**Revendications**

**1.** Dispositif photovoltaïque (100) comprenant :

un substrat (110) incluant une surface réceptrice de lumière et une surface de support ;
une région de base (140) située sur la surface arrière du substrat (110) ;
une région émettrice (150) située sur la surface arrière du substrat (110) ;
une première électrode (160) située sur la région de base (140) et présentant une première largeur d'électrode M1 mesurée dans une première direction ; et
une seconde électrode (170) située sur la région émettrice (150) et présentant une seconde largeur d'électrode M2 mesurée dans ladite première direction ;
**caractérisé en ce que** $0,3 \leq C < 1$, où $C = M1/M2$.

**2.** Dispositif photovoltaïque selon la revendication 1, dans lequel $0,4 \leq C < 1$.

**3.** Dispositif photovoltaïque selon la revendication 1 ou 2, dans lequel la largeur de la région émettrice (150) dans la première direction est supérieure à la largeur de la région de bas (140) dans la première direction.

**4.** Dispositif photovoltaïque selon la revendication 1 ou 2, dans lequel la largeur de la région de base (140) dans la première direction est supérieure à la largeur de la région émettrice (150) dans la première direction.

**5.** Dispositif photovoltaïque selon l'une quelconque des revendications précédentes, comprenant une structure de couche isolante (180) située entre la base et les régions émettrices (140 ; 150) et la première et la seconde électrode (160 ; 170).

**6.** Dispositif photovoltaïque selon la revendication 5, dans lequel la structure de couche isolante (180) comprend une couche isolante unique (680 ; 780).

**7.** Dispositif photovoltaïque selon la revendication 5, dans lequel la structure de couche isolante (180) comprend une première couche isolante (181 ; 581) et une seconde couche isolante (182 ; 582) située sur la première couche isolante (181 ; 581).

**8.** Dispositif photovoltaïque selon la revendication 5, 6 ou 7, dans lequel la structure de couche isolante (180) comprend des parties de couche isolante séparées par des ouvertures, la première électrode (160) fait contact électrique avec la région de base (140) via une première desdites ouvertures et ladite seconde électrode (170) fait contact électrique avec la région émettrice (150) via une seconde desdites ouvertures.

**9.** Dispositif photovoltaïque selon la revendication 8, dépendant de la revendication 7, dans lequel, dans chaque partie de couche isolante (180), la première couche isolante (181 ; 581) présente une largeur mesurée dans la première direction qui est supérieure à une largeur de la seconde couche isolante (182 ; 582) mesurée dans la première direction.

**10.** Dispositif photovoltaïque selon l'une quelconque des revendications 5 à 9, dans lequel la première électrode (160) recouvre une région de bord de la région émettrice (150) et ladite structure de couche isolante (180) est située entre ladite région de bord et ladite première électrode (160 ; 170).

**11.** Dispositif photovoltaïque selon l'une quelconque des revendications 5 à 10, dans lequel la seconde électrode (170) recouvre une région de bord de la région de bas (140) et ladite structure de couche isolante (180) est située entre ladite région de bord et ladite seconde électrode (170).

**12.** Dispositif photovoltaïque selon la revendication 6 ou l'une quelconque des revendications en dépendant, dans lequel la couche isolante présente une épaisseur de 8000 Å ou plus.

**13.** Dispositif photovoltaïque selon la revendication 7 ou l'une quelconque des revendications en dépendant, dans lequel chacune des couches isolantes présente une épaisseur comprise entre 500 Å et 3000 Å.

**14.** Dispositif photovoltaïque selon l'une quelconque des revendications précédentes, dans lequel la première et la seconde électrode (160; 170) sont allongées et s'étendent dans une direction perpendiculaire à la première direction.

**15.** Dispositif photovoltaïque selon l'une quelconque des revendications précédentes, dans lequel la région de base et émettrice (140; 150) sont allongées et s'étendent dans une direction perpendiculaire à la première direction.

# FIG. 1

# FIG. 2

# FIG. 3

## FIG. 4

## FIG. 5

## FIG. 6

## FIG. 7

FIG. 8A

FIG. 8B

FIG. 9

881
810

850    840    850    840

FIG. 10

H1
881
810

850    840    850    840

# FIG. 11

H1   H2

882 } 880
881

810

850   840   850   840

# FIG. 12

M2   M1

871   861   OL
(870)   (860)   871   861
(870)   (860)

882 } 880
881

810

850   840   850   840

W2   W1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102009003467 A1